# DEMANDE DE BREVET EUROPEEN

(11) **EP 4 185 091 A1**
(43) Date de publication de la demande: **24.05.2023**
(21) Numéro de dépôt: 22208666.2
(22) Date de dépôt: 21.11.2022
(51) Int. Cl.: H10N 10/10, H10N 10/13

(54) **SYSTEME DE PRODUCTION ELECTRIQUE UTILISANT DES CELLULES A EFFET SEEBECK**

(30) Priorité: 23.11.2021 FR 2112405; 28.03.2022 FR 2202764
(71) Demandeur: Bonin, Rodolphe, 73320 Tignes (FR)
(72) Inventeur: Bonin, Rodolphe, 73320 Tignes (FR)
(74) Mandataire: Touroude & Associates

(57) **Abrégé**

L'invention concerne un procédé de production d'électricité, caractérisé en ce qu'il comprend les étapes de :
(a) conversion d'énergie en chaleur à partir d'un flux d'au moins une onde électromagnétique, dans laquelle ledit flux est concentré par un élément optique, tel qu'une lentille ou un miroir ;
b) stockage de l'énergie sous forme de chaleur selon l'étape (a) sur un produit caloporteur ;
(c) production d'électricité en utilisant la chaleur stockée de l'étape (b) nécessaire pour le côté chaud dans une cellule thermoélectrique à effet Seebeck ; et
(d) récupération de l'électricité généré par l'étape de production (c). L'invention concerne également un dispositif de production d'électricité adapté pour la mise en œuvre de ce procédé, l'utilisation d'un élément optique, tel qu'une lentille de Fresnel (1), pour la mise en œuvre de ce procédé, ainsi qu'une utilisation d'un dispositif de production d'électricité selon l'invention pour fournir de l'électricité à un réseau électrique public, fournir de l'électricité domestique ou industrielle.

## Description

La présente invention concerne un système de production électrique renouvelable, ou encore dit « vert », avec un très faible bilan carbone, utilisant des cellules thermoélectriques à effet Seebeck, la chaleur nécessaire étant produite par concentration d'ondes électromagnétiques, tels que des rayons solaires, via un ou plusieurs éléments optiques tels qu'une lentille de Fresnel.

Les cellules thermoélectriques à effet Seebeck, sont généralement utilisées dans les domaines où il y a beaucoup de chaleur perdue et cette chaleur est utilisée pour des compléments de production électrique. La ou les cellules peuvent ainsi être accolée(s) à un four, ou proche ou en contact avec une flamme ou un/des gaz chauds d'échappement. Les cellules thermoélectriques à effet Seebeck ont également été utilisées dans l'aérospatial sur certaines sondes, quand les sondes voyagent trop loin pour que les panneaux solaires soient une source viable, alors en utilisant la chaleur d'une radio-pile comme sources de chaleur.

En outre, dans le cadre de production de chaleur dite « verte », la chaleur peut être collecté par d'énormes parcs de miroir, concentrant cette chaleur sur une tour où des liquides calorifiques sont chauffés. Bien que cette méthode soit verte, elle nécessite une grosse infrastructure telle qu'une tour très grande et coûteuse, de plus le liquide chauffé doit être acheminé par des conduits et pompes.

Le but de l'invention est donc de pallier les inconvénients de l'art antérieur en proposant un procédé de production d'électricité, caractérisé en ce qu'il comprend les étapes de :
(a) conversion d'énergie en chaleur à partir d'un flux d'au moins une onde électromagnétique, dans laquelle ledit flux est concentré par un élément optique, tel qu'une lentille ou un miroir ;
(b) stockage de l'énergie sous forme de chaleur selon l'étape (a) sur un produit caloporteur ;
(c) production d'électricité en utilisant la chaleur stockée de l'étape (b) nécessaire pour le côté chaud dans une cellule thermoélectrique à effet Seebeck ; et
(d) récupération de l'électricité générée par l'étape de production (c).

L'étape (c) de production d'électricité est en particulier nécessaire pour créer une différence de température avec le côté froid de la cellule.

Ainsi de manière préférée, le procédé de production d'électricité selon l'invention, peut être caractérisé en ce qu'il permet une production d'électricité pendant 24 heures généré par un flux d'au moins une onde électromagnétique pendant au moins 2 heures, au moins 3 heures, au moins 4 heures, au moins 5 heures, au moins 6 heures, au moins 7 heures, au moins 8 heures, au moins 9 heures, au moins 10 heures, au moins 11 heures ou encore au moins 12 heures.

Dans un mode de réalisation particulier, le procédé de production d'électricité selon la présente invention, peut être caractérisé en ce que la quantité et/ou la qualité de produit caloporteur de l'étape (a) et (b) sont adaptées pour une production d'électricité jour-et-nuit lorsque le flux d'au moins une onde électromagnétique provient du soleil.

Dans un mode de réalisation préféré, le procédé de production d'électricité selon l'invention, peut être caractérisé en ce que la quantité et/ou la qualité de produit caloporteur de l'étape (b) sont adaptées pour un fonctionnement d'au moins 1 jour, préférentiellement au moins 2 jours, voire au moins 3 jours sans une étape (a) de conversion d'énergie en chaleur à partir d'un flux d'au moins une onde électromagnétique.

En outre, le procédé de production d'électricité selon l'invention, peut être caractérisé en ce que l'élément optique est une lentille de Fresnel. Les lentilles de Fresnel sont en effet connues depuis longtemps et sont pour cette raison des éléments faciles à façonner pour permettre une collecte optimale d'énergie.

En outre, le procédé de production d'électricité selon l'invention, peut être caractérisé en ce que l'élément optique est un miroir, façonné de manière à concentrer le flux d'onde(s) électromagnétique, par exemple par un miroir concave.

Dans un mode de réalisation particulier, le procédé de production d'électricité selon la présente invention, peut être caractérisé en ce que le produit caloporteur de l'étape (b) est un sel fondu ou susceptible de fondre lorsqu'il est soumis au flux concentré par un élément optique.

Dans un mode de réalisation particulier, le procédé de production d'électricité selon la présente invention, peut être caractérisé en ce que le sel fondu est choisi dans la liste consistant en du nitrate de lithium, nitrate de calcium, nitrate de sodium et nitrate de potassium.

Dans un mode de réalisation préféré, le procédé de production d'électricité selon l'invention, peut être caractérisé en ce que le produit caloporteur de l'étape (b) est chauffé par une source d'énergie supplémentaire, c'est-à-dire supplémentaire vis-à-vis de la conversion d'énergie en chaleur à partir d'un flux d'au moins une onde électromagnétique

Dans un mode de réalisation préféré, le procédé de production d'électricité selon l'invention, peut être caractérisé en ce que la source d'énergie supplémentaire provient d'une source artificielle.

De manière préférée, le procédé de production d'électricité selon l'invention, peut être caractérisé en ce que la source d'énergie supplémentaire est concentrée par le biais d'un échangeur thermique ou d'une pile à chaleur extérieure.

Dans un mode de réalisation particulier, le procédé de production d'électricité selon la présente invention, peut être caractérisé en ce que le produit caloporteur de l'étape (b) est chauffé par une source d'énergie supplémentaire, par exemple provenant d'une source artificielle telle que concentrée par le biais d'un échangeur thermique ou d'une pile à chaleur extérieure.

L'objet de la présente invention concerne également un dispositif adapté pour la mise en œuvre du procédé décrit ci-dessus.

Plus particulièrement, l'objet de la présente invention concerne un dispositif adapté pour la mise en œuvre du procédé décrit ci-dessus pouvant être caractérisé en ce qu'il comprend :
- un élément optique, tel qu'une lentille ou un miroir comme décrit ci-dessus ;
- un produit caloporteur disposé de manière à recevoir l'énergie issue d'un flux d'au moins une onde électromagnétique concentré par l'élément optique ;
- au moins une cellule thermoélectrique à effet Seebeck comprenant un corps froid configuré pour générer une différence de température avec le produit caloporteur ; et
- au moins un moyen de récupération de l'électricité produite.

Dans un mode de réalisation particulier, le dispositif selon la présente invention peut être caractérisé en ce que le produit caloporteur est isolé de l'extérieur.

De manière préférée, le produit caloporteur est placé dans un compartiment préférentiellement hermétique.

De manière préférée, le dispositif selon la présente invention peut être caractérisé en ce que le produit caloporteur est placé dans un compartiment dont l'humidité est contrôlée par exemple par un clapet de pression permettant l'introduction d'un gaz inerte tel que l'azote.

Dans un mode de réalisation particulier, le dispositif selon la présente invention peut être caractérisé en ce que les parois dudit dispositif sont fabriqués en un matériau anticorrosif.

De manière préférée, le dispositif selon la présente invention peut être caractérisé en ce que le matériau anticorrosif comprend du verre.

De manière préférée, le dispositif selon la présente invention peut être caractérisé en ce qu'il comprend une cage de verre.

Par « cage de verre », il est compris dans le contexte de la présente invention une loge vitrée (donc en verre).

Dans un mode de réalisation particulier, le dispositif selon la présente invention peut être caractérisé en ce qu'au moins une partie des parois comprends un matériau permettant une diffusion facilitée de la chaleur, tel que le graphène, préférentiellement la cellule thermoélectrique à effet Seebeck est en contact avec le matériau permettant une diffusion facilitée de la chaleur.

Dans un mode de réalisation particulier, le dispositif selon la présente invention peut être caractérisé en ce qu'il comprend une enceinte métallique dans laquelle est disposé un compartiment, préférentiellement en verre, comprenant le produit caloporteur.

De manière préférée, le dispositif selon la présente invention peut être caractérisé en ce que l'enceinte métallique et le compartiment, préférentiellement en verre, comprenant le produit caloporteur sont séparés par un espace pouvant être rempli par un gaz tel que de l'air.

L'objet de la présente invention concerne également une utilisation d'un élément optique, tel qu'une lentille de Fresnel ou un miroir, pour concentrer un flux d'au moins une onde électromagnétique avec une cellule thermoélectrique à effet Seebeck comprenant un corps froid, dans laquelle l'élément optique est orienté de manière à chauffer un produit caloporteur.

Comme précédemment décrit, l'élément optique peut être une lentille (comme une lentille de Fresnel) ou un miroir, comme décrit ci-dessus.

Dans un mode de réalisation particulier, l'utilisation selon la présente invention peut être caractérisé en ce que le produit caloporteur est un sel fondu ou susceptible d'être fondu lorsqu'il est soumis au flux concentré par un moyen optique, dans le but de stocker de l'énergie thermique, dans ledit sel fondu afin d'être utilisé comme une pile thermique.

De manière préférée, l'utilisation selon la présente invention peut être caractérisé en ce que le sel fondu est choisi dans la liste consistant en du nitrate de lithium, nitrate de calcium, nitrate de sodium et nitrate de potassium.

L'objet de la présente invention concerne également une utilisation d'un dispositif de production d'électricité tel que décrit ci-dessus pour fournir de l'électricité à un réseau électrique public, fournir de l'électricité domestique ou industrielle.

### Commentaires

Un fait intéressant ici, se trouve dans le fait d'apporter la solution d'une source de chaleur renouvelable, avec en particulier une logistique moindre, par l'utilisation de la chaleur solaire concentrée à travers un élément optique telle qu'une lentille de Fresnel, pour la face chaude de la cellule et pour la face froide, on utilise une source d'eau froide provenant d'un bassin, par exemple, pouvant être soit naturel ou artificiel remplis par de l'eau courante.

Alternativement par l'utilisation de la chaleur solaire concentrée à travers une élément optique telle qu'une lentille de Fresnel, et une cuve dans laquelle le produit caloporteur tel qu'un sel de métal ou de préférence du nitrate de lithium se trouve, et ne circule pas. Ceci élimine les conduits et les pompes pour son acheminement de la tour au système utilisant le liquide calorifique. Le système produit alors une électricité dite « verte » et décarbonée.

L'invention utilise en particulier le principe thermoélectrique à l'effet Seebeck pour créer de l'électricité verte renouvelable et décarbonée.

L'élément optique telle que la lentille de Fresnel concentre un rayonnement électromagnétique tel que le rayonnement solaire et utilise cette chaleur pour chauffer un produit caloporteur tel qu'un sel de métal (préférentiellement fondu), de préférence le nitrate de lithium. La chaleur emmagasinée peut être utilisée comme stockage thermique ou pile solaire.

L'invention a l'avantage de fonctionner et de restituer la chaleur même en absence de rayonnement électromagnétique tel que le rayonnement solaire (i.e. dans l'obscurité), tel que pendant la nuit. Le système utilise un rayonnement électromagnétique tel que le rayonnement solaire comme source de chaleur, mais n'a pas besoin du rayonnement électromagnétique pour restituer cette énergie sous forme d'électricité, étant donné que c'est une différence de températures (chaud contre froid) combiné avec une cellule à effet Seebeck permet cet effet.

Par exemple, pour un fonctionnement 24h sur 24 h, il faut adapter la surface en mètres carrés (m²) d'élément(s) optique(s) telles que des lentilles de Fresnel et la quantité de produit caloporteur tel qu'un sel de métal fondu (de préférence le nitrate de lithium) de manière à ce que la quantité de produit caloporteur soit suffisamment chauffée pour permettre un stockage thermique suffisant pour le fonctionnement.

Ceci peut être facilement déterminé en ajustant d'abord la quantité et la nature du produit caloporteur en fonction de la ou des cellules thermoélectriques à effet Seebeck utilisée(s) (chauffage artificiel avec relargage dans l'obscurité et mesure de l'électricité ainsi fournie). Ensuite, le ou les élément(s) optique(s) telles que des lentilles de Fresnel sont adaptées pour fournir les calories nécessaires au produit caloporteur.

La cellule thermoélectrique à effet Seebeck se caractérise par la production de l'électricité via une différence de température, soumise à plusieurs de ses faces (en générale deux). En d'autres termes, quand une source chaude et une source froide sont chacune en contact avec chacune des deux faces d'une cellule thermoélectrique à effet Seebeck, une production d'électricité se produit (correspondant donc à la différence entre le chaud et le froid qui est en contact avec ces faces).

Dans un mode de réalisation particulier, le dispositif selon la présente invention offre une solution dite verte et décarboné de production électrique par le biais de cellule thermoélectrique a effet Seebeck. La chaleur est produite par une synergie de moyens, telle que la concentration de rayon solaires par lentille de Fresnel, pour fondre un médium (produit) caloporteur (tel que le nitrate de lithium), apportant la chaleur nécessaire à au moins une cellule thermoélectrique a effet Seebeck. Par conduction thermique, le froid étant apporté par un liquide froid circulant dans un autre réservoir, pouvant être de l'eau froide, le système peut fonctionner même après le coucher du soleil. Si on utilise des récipients préalablement chauffés par la lentille durant la journée, comme des accumulateurs thermiques (pile a chaleur), celles-ci peuvent restituer la chaleur pendant la nuit par conduction thermique de la même manière que le système diurne. Les réservoir de produit caloporteur (tel qu'un sel fondu) peuvent en outre être placés si besoin sur un ensemble appelé chariot remplaçant le container de chaleur épuiser, fournissant ainsi une solution constante en journée et/ou pendant la nuit.

En outre, certains aspects de la présente invention peuvent être décrits sous forme de clauses :
Clause 1 : le procédé est dit vert ou renouvelable car la chaleur nécessaire au fonctionnement des cellules thermoélectrique à effet Seebeck est produite par le rayonnement solaire passant à travers une lentille de Fresnel (1), utilisé pour fondre du nitrate de lithium, ou une autre solution ayant un rôle caloporteur, de préférence nitrate de lithium pour ces qualités de stockage et restitution thermique.
Clause 2 : L'isolation par les parties en verre (18),(19),(20), du sandwich, et le système de vis ou rivets du haut et du bas ont pour but d'empêcher au maximum le réchauffement de la plaque (16), par conduction thermique de la plaque (15).
Clause 3 : La chaleur du nitrate de lithium ou autre medium caloporteur, fondue est utilisé pour transmettre par conduction thermique la chaleur nécessaire au cellule thermoélectrique Seebeck, pour le coté chaud de la cellule.
Clause 4 : Le contenant du medium caloporteur est hermétique à l'air à une atmosphère au niveau de la mer, grâce à un clapet de pression, (9), ayant pour but de permettre d'aspirer l'air ambiant, afin de le remplacer par de l'azote gazeux, dans le but de limiter l'absorption de l'humidité de l'air ambiant par le nitrate de lithium, et de remplir la cuve en nitrate de lithium.
Clause 5 : Le design de la cage de verre en forme de cube (6) et sans parois du fond, le fond (7) étant en matériau de conduction thermique le plus élevé possible et sceller à la cage de verre (6) constituant un seul ensemble hermétique le matériau du fond étant de préférence le graphène. Le verre de la cuve en verre (6) a l'avantage de limiter la corrosion et l'abrasion sur des parties qui seraient sinon en métal ou sensible à la corrosion ou oxydation par exemple. 6) Les pertes thermiques sont minimiser par le design de type thermos, par les parois de verre (6), et l'espace d'air (8) entre le verre et la paroi aluminium (5) contenant de l'air, permettant que le maximum de chaleur soit conservé et utilisé par conduction thermique à travers le graphène (7).
Clause 6 : Le sandwich (15)(18)(17)(19)(16)(20) maintenant les cellules thermoélectriques au milieu du sandwich, offre une solution a la fois de bon rendement de conduction thermique aux cellules (17) aussi bien pour le coté chaud et coté froid du fait de la propriété thermique du graphène, et assure aussi un principe isolant par les parties (18) (19) (20) minimisant une conduction thermique de la partie (15) a (16).
Clause 7 : La partie haute A1 et la partie basse A2 sont séparable, permettant de remplacer la partie haute contribuant à un constant apport de chaleur par conduction thermique, par une nouvelle partie haute agissant comme stockage thermique, « pile à chaleur » ou pile solaire, offre la solution de fonctionner sans soleil et ou pendant la nuit.
Clause 8 : Le vérin permet de descendre et de remonter à la fois la partie basse, et le cube thermos, lors du changement de la partie haute.
Clause 9 : Le système de chariot mobile permet le changement de partie haute, automatiquement permettant un apport de chaleur par conduction thermique, par la solution de remplacement d'une autre partie haute ayant le rôle de pile à chaleur, pouvant servir lors d'absence de soleil, ou de nuit. Pour que le système continue de produire de l'électricité.

On décrira ci-après, à titre d'exemples non limitatifs, des formes d'exécution de la présente invention, en référence aux figures annexées sur lesquelles :
[Fig.1] est une vue d'ensemble du dispositif selon l'invention.
[Fig.2] représente un système avec une lentille (par exemple une lentille de Fresnel) comportant un cadre et un système de suivi du soleil, et sa fixation au sol.
[Fig.3] représente une vue de profile de la figure 2.
[Fig.4] représente un système de la lentille (telle qu'une lentille de Fresnel) disposé de manière à chauffer une partie supérieure d'une cuve selon la présente invention.
[Fig.5] représente une vue de dessus d'une cuve selon la présente invention.
[Fig.6] est une vue éclatée en perspective de tous les éléments de la figure 5.
[Fig.7] représente une variante d'une cuve selon la présente invention avec une partie supérieure en verre.
[Fig.8] représente une vue de profile avec une partie haute et une partie basse du dispositif selon la présente invention.
[Fig.9] représente une cellule thermoélectrique à effets Seebeck, pour la compréhension des deux différentes face et leur utilisation.
[Fig.10] représente la partie basse, et tous les éléments dont elle est composée.
[Fig.11] représente une vue de face de la FIG10.
[Fig.12] représente une vue en perspective d'une partie basse du dispositif en sandwich.
[Fig.13] représente une autre vue en perspective de la partie basse du dispositif en sandwich selon la figure 12 avec des éléments supplémentaires.
[Fig.14] représente une vue en perspective éclatée de la partie basse du dispositif en sandwich.
[Fig.15] est une représentation aidant la compréhension d'un mode de réalisation décrit dans l'exemple ci-dessous.
[Fig.16] est une représentation aidant la compréhension d'un mode de réalisation décrit dans l'exemple ci-dessous.
[Fig.17] est une représentation aidant la compréhension d'un mode de réalisation décrit dans l'exemple ci-dessous.
[Fig.18] est une représentation aidant la compréhension d'un mode de réalisation décrit dans l'exemple ci-dessous.

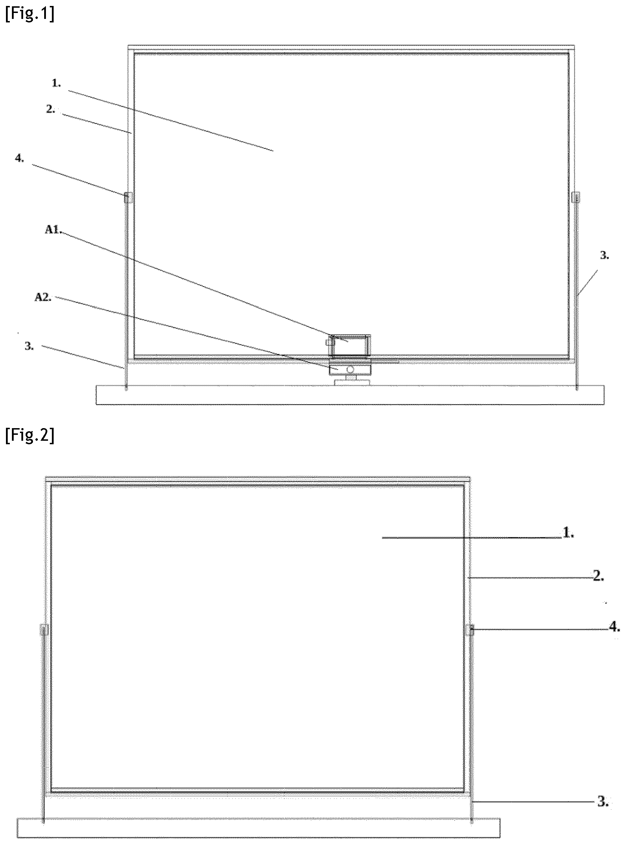

En référence aux figures 1, 2, 3 et 4, il peut être identifié un élément optique, telle qu'une lentille de Fresnel 1, tenue par un cadre 2 (aussi appelé cadre porteur ou cadre mobile). Ce cadre 2 est attaché à des bras 3, relié à au moins un moteur 4. La lentille de Fresnel 1 est agencée pour être focalisée sur une partie haute A1 du dispositif selon la présente invention. Cette partie haute A1 est positionnée sur une partie basse A2.

Plus précisément en figure 2, le cadre 2 de la lentille de Fresnel 1 est orientable par le moteur 4 (pouvant être un moteur électrique et/ou un moteur pas à pas), lequel moteur pouvant être par exemple du type pas à pas, pour suivre la course du soleil, afin de garder son orientation de concentration des rayons solaires sur un point focale du point chaud sur la première plaque supérieure 11.

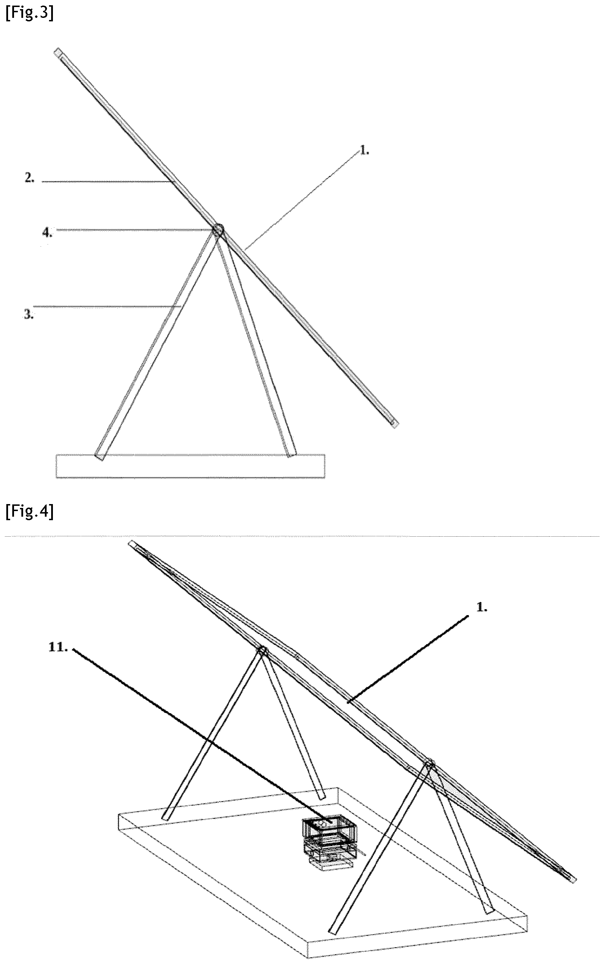

En figure 4, le cadre 2, a une forme carrée et est construit afin de loger des moteurs 4, dans des logements ronds situés sur les côtés du cadre 2. Le cadre 2 est fixé par des bras 3 (lesquels bras peuvent être en métal), lesquels ont pour fonction de maintenir, les moteurs 4, le cadre 2 (ce dernier maintenant la lentille de Fresnel 1. Les bras 3 sont scellés au sol.

En outre, sur la figure 4, le rayonnement solaire passe à travers une lentille de Fresnel 1 maintenue dans son cadre 2, le rayonnement solaire est concentré par cette lentille de Fresnel et est orientée et focalisée de façon à obtenir une température souhaitée sur un point focal précis, dans le but de maintenir la température souhaitée, comme le ferait un homme du métier ou un ingénieur spécialisé en science de l'optique.

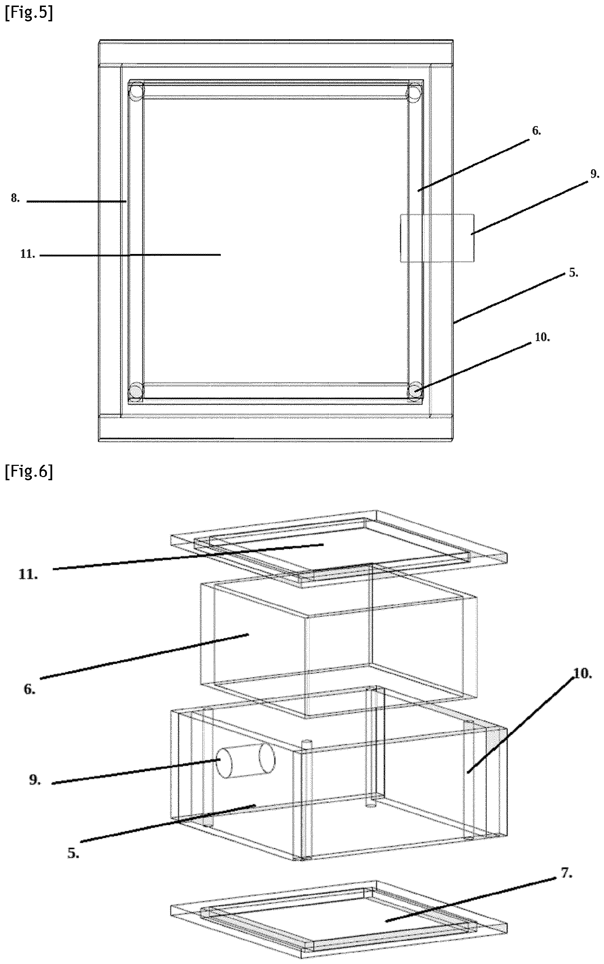

Le point chaud de la lentille de Fresnel est utilisé figure 4 et figure 5 pour chauffer une première plaque supérieure 11 de préférence en graphène ou dans un matériau a haute conduction thermique, ou la première plaque supérieure 11 peut être remplacée par du verre.

Dans les figures 5, 6 et 7, la dénomination de partie haute A1 comprend le récipient de produit caloporteur sous forme de sel susceptible d'être fondu, tel que le nitrate de lithium, c'est-à-dire tous les éléments suivants : la première cuve 5, la seconde cuve 6, le fond de cuve 7, l'espace 8 ainsi généré, la valve de pression 9, les premiers rivets 10 et la première plaque supérieure 11 en un seul ensemble compact.

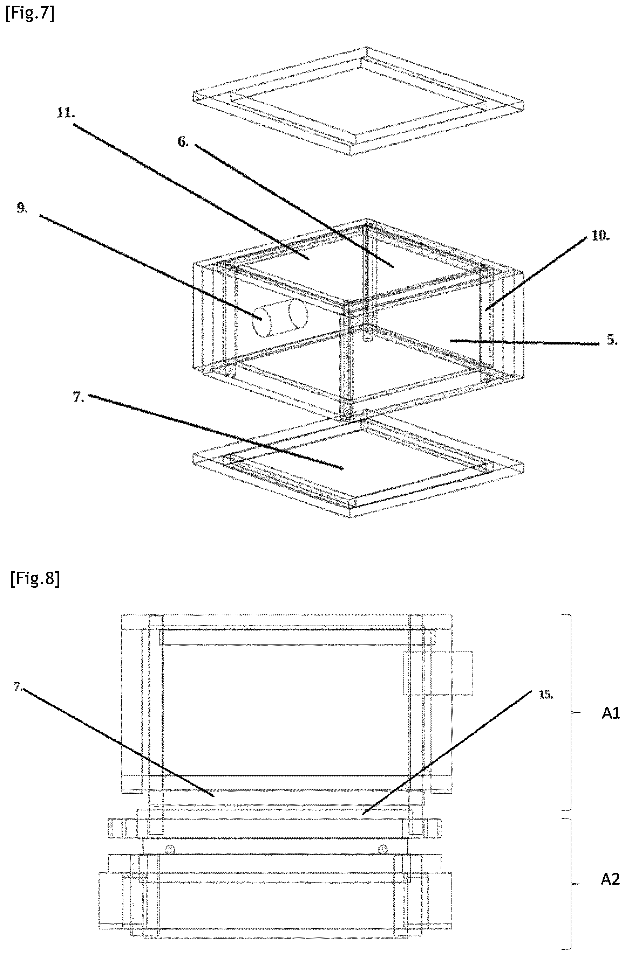

En référence à la figure 5, la seconde cuve 6 peut être une cuve en verre sans fond (comme représenté à la figure 7), utilisant le rayonnement pour chauffer le sel de métal au lieu d'un chauffage par convection. Une première plaque supérieure 11 en matériau à haute conduction thermique peut être utilisée. Dans tous les cas, le but est d'emmagasiner de l'énergie thermique dans un produit caloporteur tel qu'un sel susceptible d'être fondu (par exemple le nitrate de lithium), devant être injecté à l'intérieur de la seconde cuve 6 (laquelle seconde cuve 6 étant éventuellement en verre).

En figure 5 est représenté une cuve dans son ensemble, comprenant une seconde cuve 6 prenant une forme de cube en verre sans fond, une première plaque supérieure 11 de la seconde cuve 6 en graphène de préférence, ou en verre et scellée par des premiers rivets 10 lesquelles permettent de sceller tout du long et de haut en bas en traversant la première cuve 5 les quatre coins de la seconde cuve 6, le fond de cuve 7 et la première plaque supérieure 11. Le fond de cuve 7 est construit dans un matériel à haut coefficient de conduction thermique de préférence en graphène pour ces qualités de conduction thermique, mais peut être construit avec un autre matériau présentant une très bonne conduction thermique.

En figure 5, à l'extérieur des côtés de la seconde cuve 6 une première cuve 5 l'entoure, comportant un espace 8 entre la première cuve 5 et les parois en verre de la seconde cuve 6 l'espace 8 pouvant être rempli d'air, ajoutant en principe une isolation thermique.

En figure 5, l'intérieur de la seconde cuve 6 peut être en verre avec un fond de cuve 7 en graphène hermétique et présentant une pression d'une atmosphère à 0 M au niveau de la mer. Une telle pression peut ainsi être considérée comme satisfaisante.

En figure 5, une valve de pression 9 (pouvant aussi être appelé clapet de pression) traverse la première cuve 5 et la seconde cuve 6 percée pour accueillir la valve de pression 9 prévue à cet effet.

En figure 5, la valve de pression 9 est située sur au moins l'un des côtés de la première cuve 5 et de la seconde cuve 6, cette dernière pouvant être en verre. L'utilité de cette valve de pression 9 est d'aspirer l'air ambiant de l'ensemble comprenant la première cuve 5, la seconde cuve 6, la première plaque supérieure 11 et le fond de cuve 7. Le but est ainsi d'enlever l'oxygène et le maximum d'humidité de l'air à l'intérieur de celle-ci, et de remplir l'ensemble comprenant la première cuve 5, la seconde cuve 6, la première plaque supérieure 11 et le fond de cuve 7 par un gaz inerte tel que l'azote, a une pression d'une atmosphère.

En figure 5 et dans le cas de l'utilisation du nitrate de lithium, celui-ci étant corrosif et oxydant, le fait d'ajouter des parois en verre permet de réduire fortement le problème de corrosion et d'oxydation. De plus, le fait d'ajouter des parois en verre permet de réduire le remplacement fréquent des constituant du dispositif selon la présente invention et en particulier la première cuve 5, la seconde cuve 6, la première plaque supérieure 11 et le fond de cuve 7.

De plus en figure 5, le fait d'avoir un espace 8 pouvant être un espace d'air entre les parois latérales de verre de la seconde cuve 6 et la première cuve 5 apporte une solution pour minimiser la perte thermique (par les côtés de la première cuve 5 et de la seconde cuve 6).

En outre en figure 5, la valve de pression 9 permet de vider l'air ambiant trouvé en dessous de la première plaque supérieure 11, la seconde cuve 6 et le fond de cuve 7 et de le remplacer par un gaz inerte tel que l'azote. Ceci permet d'éviter qu'un produit caloporteur sensible à l'oxydation ou à l'humidité, tel que le nitrate de lithium, puisse absorber de l'humidité de l'air ambiant. Le produit caloporteur, tel que du nitrate de lithium, peut être injecté ensuite par la valve de pression 9 seulement au moment où l'air ambiant a été aspiré et a été remplacé par un gaz inerte tel que l'azote à une atmosphère par exemple.

En figure 6, du nitrate de lithium peut être contenu dans la seconde cuve 6, la première plaque supérieure 11 et du fond de cuve 7.

Lorsque le produit caloporteur est un sel susceptible d'être fondu, tel que le nitrate de lithium, celui-ci peut ensuite être fondu grâce à la lentille de Fresnel 1 réglée de manière à atteindre la température nécessaire à travers la première plaque supérieure 11. Le réglage de ma lentille de Fresnel peut se faire par exemple en réglant le point focal du point chaud sur le produit caloporteur. Il est donc possible d'utiliser le produit caloporteur sous forme de sel susceptible d'être fondu, tel que le nitrate de lithium comme source de chaleur par conduction thermique à travers le fond de cuve 7 en graphène en remplacement d'une flamme ou résistance.

En référence à la figure 7, il peut être vu une première cuve 5 (extérieure) dans laquelle une seconde cuve 6 (intérieure) est positionnée. La première cuve présente une valve de pression 9. La seconde cuve 6 comprend quatre premiers rivets 10. L'ensemble première cuve 5 et seconde cuve est coiffé par une première plaque supérieure 11.

En figure 8, il peut être vu que la seconde plaque supérieure 15 transmet de la chaleur la vers face supérieure de la cellule thermoélectrique 17.

En référence à la figure 8, un système refroidissement par liquide est classique. Ainsi, un liquide froid circule à l'aide d'une pompe à eau, passant à l'intérieur du réservoir 14 par une entrée 14A en le remplissant complètement, et en ressortant sur le côté opposé au niveau de la sortie 14B. Dans un mode de réalisation, le liquide peut être de l'eau froide, provenant d'un bassin ou autre, retournant dans le bassin pour y être refroidi naturellement par déperdition thermique. Ensuite, le liquide est pompé à nouveau du bassin dans le réservoir 14 circulant de la même manière que précédemment en passant par l'entrée 14A et évacué par la sortie 14B.

En figure 8 est illustré un dispositif selon la présente invention comprenant deux parties distinctes, nommées partie haute A1 et partie basse A2.

La partie haute A1 comprend une première cuve 5, un fond de cuve 7, une valve de pression 9, et une première plaque supérieure 11.

La partie basse A2 comprends un réservoir 14, une entrée 14A, une sortie 14B, une seconde plaque supérieure 15, une cellule thermoélectrique 17, une troisième plaque supérieure 18, une deuxième plaque médiane 19, des seconds rivets 20 et des troisièmes rivets 20A.

Pour une bonne mise en contact de la partie haute A1 avec la partie basse A2 également référencée comme « sandwich » dans le contexte de la présente invention, la seconde plaque supérieure 15 en graphène, a de préférence un diamètre et/ou une forme géométrique proche ou identique aux diamètre et/ou forme géométrique de la plaque de graphène du fond de cuve 7. En effet, le but étant de pouvoir mettre en contact la plaque de graphène du fond de cuve 7 avec la seconde plaque supérieure 15 en graphène pour assurer une conduction thermique entre le fond de cuve 7, et la seconde plaque supérieure 15, à travers les plaques de graphène.

Ainsi en permettant le transfert de chaleur du produit caloporteur sous forme de sel susceptible d'être fondu, tel que le nitrate de lithium, à travers le fond de cuve 7 en graphène, à la seconde plaque supérieure 15, par conduction thermique à la seconde plaque supérieure 15, il est réalisé une différence de température entre les faces supérieures et inférieures de la cellule thermoélectrique 17.

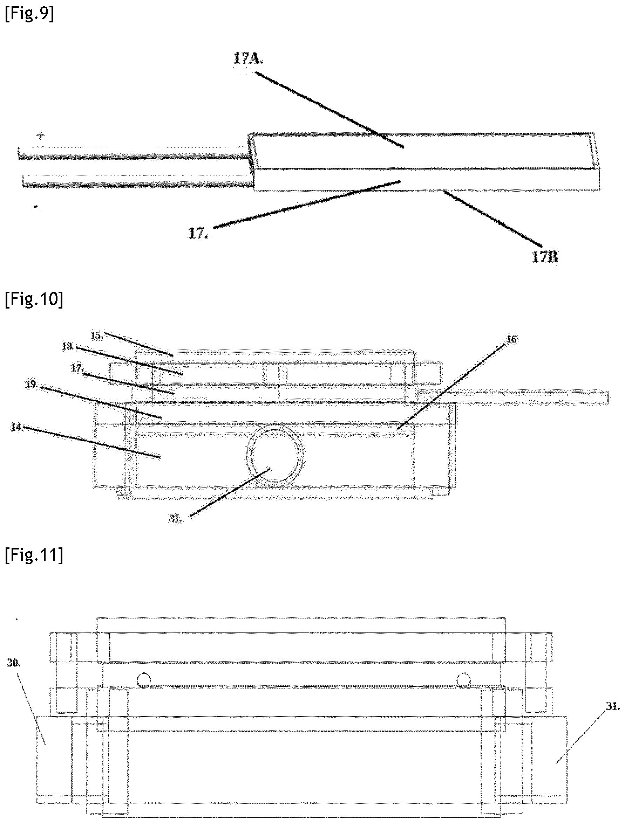

En figure 9, il est illustré une cellule thermoélectrique à effet Seebeck de forme carrée et plate, avec une face supérieure 17A dite « chaude », et une face inférieure 17B dite « froide ».

Le dispositif selon l'invention utilise par conduction thermique l'énergie thermique du produit caloporteur tel qu'un sel susceptible d'être fondu (par exemple le nitrate de lithium), pour le coté chaud de la cellule Seebeck, cf. figure 9 (face supérieure 17A).

En figure 9, il est compréhensible que la face inférieure 17B doit être maintenue froide.

Dans les figures 10 et 11, la dénomination (A2) comprend tous les éléments suivants : le réservoir 14, l'entrée 14A, la sortie 14B, la seconde plaque supérieure 15, la première plaque médiane 16, la cellule thermoélectrique 17, la face supérieure 17A, la face inférieure 17B, la troisième plaque supérieure 18, la deuxième plaque médiane 19 et les seconds rivets 20.

En particulier dans la figure 10, la troisième plaque supérieure 18, la seconde plaque supérieure 15 et la deuxième plaque médiane 19 sont maintenues ensembles par les seconds rivets 20.

En particulier également dans la figure 10, sur la partie basse de la figure 10, il peut être vu un réservoir 14 pouvant être en aluminium ayant une entrée 14a et une sortie 14b pour la circulation d'un liquide froid à l'intérieur dudit réservoir 14.

La face inférieure de la cellule thermoélectronique peut être maintenue froide grâce à un liquide de refroidissement, qui s'écoule dans le réservoir 14 de l'entrée 14A à la sortie 14B traversant le réservoir 14. L'eau froide a pour but d'absorber la chaleur qui arrive à la première plaque médiane 16 après la conversion Seebeck jouant ainsi le rôle de dissipateur de chaleur.

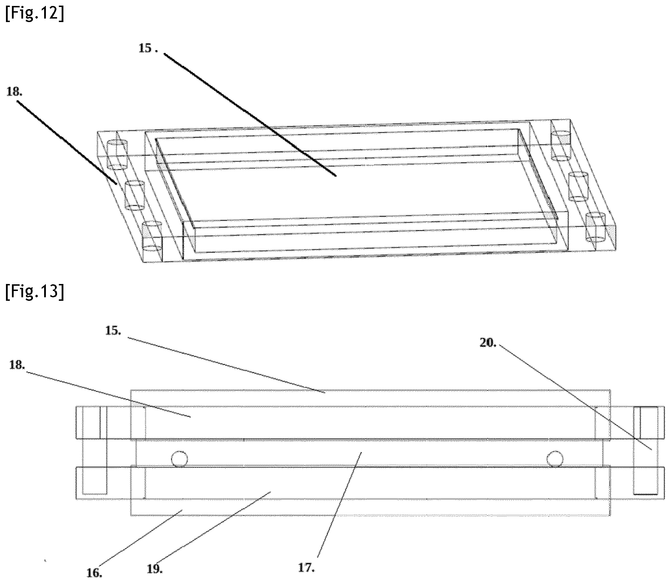

En figure 12, la seconde plaque supérieure 15 troisième plaque supérieure 18 est construite de la même manière que la deuxième plaque médiane 19 et la première plaque médiane 16, trouvée en figure 13.

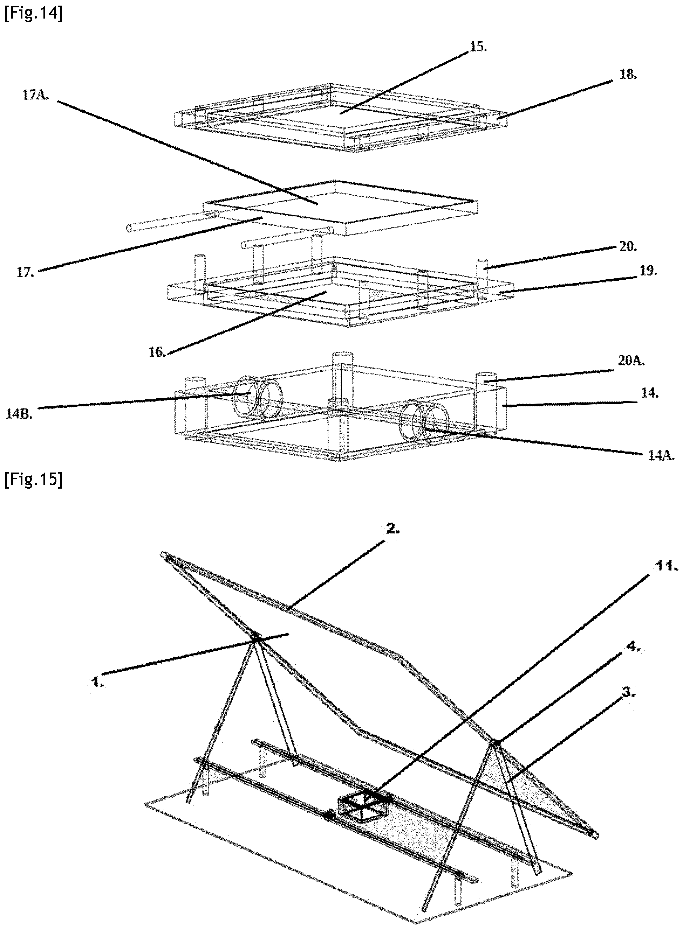

En figure 13, il est représenté un système de sandwich maintenu sur le réservoir 14 par des second rivets 20 et les troisièmes rivets 20A. Le sandwich FIG 13 a au moins deux rôles. Un premier rôle est de maintenir la ou les cellules thermoélectriques 17 plaquées entre la seconde plaque supérieure 15 de graphène et la première plaque médiane 16. Un second rôle (comme illustré en figure 14, qui comprend les mêmes éléments que les autres figures) permet un bon transfert de chaleur et/ou un bon transfert de froid par conduction à la cellule thermoélectrique 17.

De plus, en figure 13, par le biais d'une troisième plaque supérieure 18 pouvant être en verre et la présence des seconds rivets 20, une isolation thermique ou une limitation de conduction thermique peuvent être obtenus en particulier entre la troisième plaque supérieure 18 en combinaison avec la seconde plaque supérieure 15 et la deuxième plaque médiane 19 en combinaison avec la première plaque médiane 16.

En figure 13 est illustré une seconde plaque supérieure 15 en graphène ou autre matériel à haute conductivité thermique, scellé au milieu de la troisième plaque supérieure 18, laquelle troisième plaque supérieure 18 peut être en verre ou un autre matériel isolant, mais pouvant (voire devant) résister à une température de plus de 300 dégrées Celsius.

En figure 13, la deuxième plaque médiane 19 est maintenue au réservoir 14 par les troisièmes rivets 20A.

En figure 13, il est représenté un sandwich maintenant en contact les cellules thermoélectriques 17 entre la seconde plaque supérieure 15 (pouvant être en graphène) et la première plaque médiane 16. Les faces d'une ou des cellules thermoélectriques 17 permettent une bonne conduction thermique du graphène aux deux côtés des cellules thermoélectriques.

L'eau étant en contact avec la première plaque médiane 16 telle que représentée en figure 13, celle-ci absorbe la chaleur en trop. Comme la première plaque médiane 16 est en contact avec la face inférieure de la cellule thermoélectronique, cela permet à la face inférieure de la cellule thermoélectrique 17 de rester à une température dite froide. La face de la première plaque médiane 16 a donc pour but le transfert du froid à la face inférieure de la cellule thermoélectrique 17.

L'eau ayant une capacité thermique très élevée, cette propriété lui permet une grande absorption thermique, pour une élévation thermique de quelques degrés Celsius seulement. Ainsi, il peut être vu sur la figure 13 que, grâce à la mise en contact de l'eau (relativement froide) avec une première plaque médiane 16 pendant un cycle Seebeck, l'eau permettra de maintenir froide par conduction thermique la face inférieure de la cellule thermoélectrique 17. A titre d'exemple, une quantité d'eau ayant une température de dix degré Celsius (idéalement pompée a une certaine vitesse pour assurer un brassage) dans le réservoir 14 selon la figure 10 permet un bon fonctionnement du dispositif selon l'invention, en absorbant la chaleur pour atteindre par exemple trente degrés Celsius.

Le verre est un matériau pouvant résister à des températures relativement élevées sans fondre ou prendre feu, tout en conservant ses propriétés isolantes (i.e. un matériau thermiquement non-conducteur). En référence avec les figures 12 et 13, le verre peut ainsi être choisi pour entourer les pièces comprenant du graphène (c'est-à-dire le couple « seconde plaque supérieure 15 - troisième plaque supérieure 18 » et le couple « deuxième plaque médiane 19 - première plaque médiane 16 »), est ainsi limiter le transfert de chaleur pour chaque couple et au niveau des seconds rivets 20 avec les deuxièmes plaques médianes 19.

### Exemple

On décrira ci-après, à titre d'exemple non limitatif, des formes d'exécution de la présente invention, en référence aux figures.

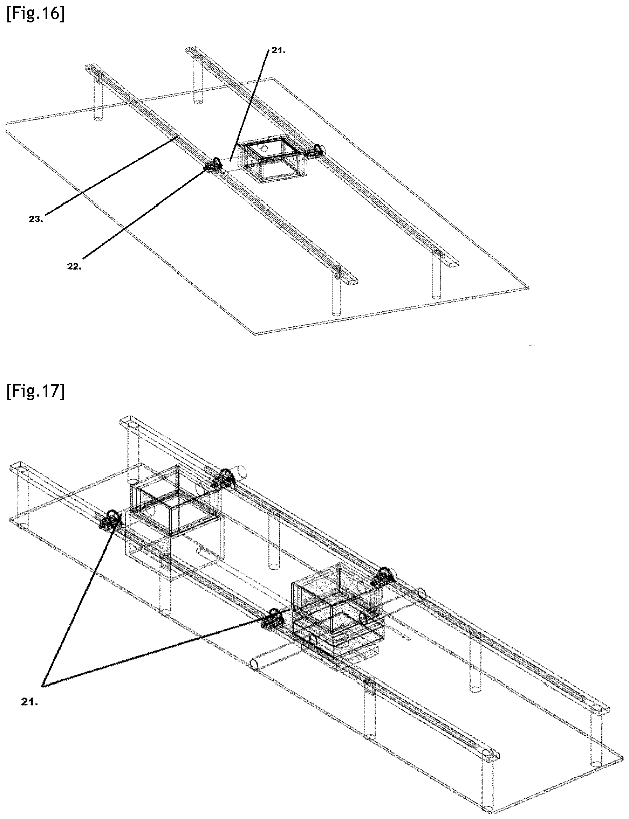

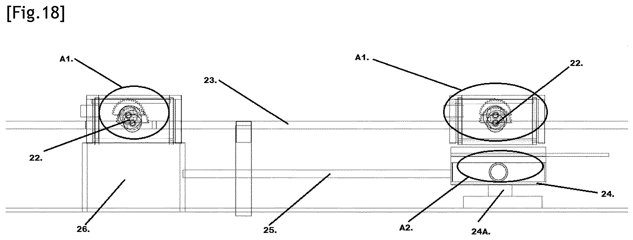

La présente invention concerne en particulier un système de production électrique renouvelable dit vert avec un très faible bilan carbone, utilisant des cellules thermoélectriques à effet Seebeck la chaleur nécessaire étant produite par concentration de rayon solaire via une ou plusieurs lentilles de Fresnel. Les cellules thermoélectriques à effet Seebeck, sont généralement utilisées dans les domaines où il y a beaucoup de chaleur perdus et cette chaleur est utilisées pour des compléments de production électrique, telle que accolé à un four, ou à l'utilisation d'une flamme, ou des gaz chaud d'échappement, ou encore elles ont été utilisées dans l'aérospatial sur certaines sondes, quand les sondes voyagent trop loin pour que les panneaux solaires soient une source viable, alors utilisant la chaleur d'une radio-pile comme sources de chaleur dans ce cas. La nouveauté ici, se trouve dans le fait d'apporter la solution d'une source de chaleur renouvelable, par l'utilisation de la chaleur solaire concentrée à travers une lentille de Fresnel, pour la face chaude de la cellule et pour la face froide, on utilise une source d'eau froide provenant d'un bassin par exemple. Qui peut être soit naturel ou artificiel remplis par de l'eau courante, en addition de ceci, la lentille de Fresnel peut aussi chauffer un médium comme le nitrate de lithium, pour utiliser la chaleur emmagasinée et la restituer lors d'absence de soleil ou pendant la nuit, comme stockage thermique ou pile solaire. L'invention utilise le principe thermoélectrique à l'effet Seebeck pour créer de l'électricité verte renouvelable et décarbonée. La cellule thermoélectrique à effet Seebeck se caractérise par le fait de produire de l'électricité par le biais d'une différence ou delta de température, soumis à ces faces, en autres termes, quand une source chaude et froide est en contact avec ces deux faces, une production d'électricité se produit, correspondant à la différence entre le chaud et le froid qui est en contact avec ces faces. La figure 15 représente la vue d'ensemble du système la partie dit haute A1, comprenant la cuve, hermétique contenant le nitrate de lithium, plus le système de chariot bras de support de cuve, les moteurs électrique servant au changement de partie A1, plus le rail sans le système Fresnel. Deux systèmes selon la figure 15 peuvent être juxtaposés l'un à côté de l'autre. La figure 6 représente tous les éléments de la cuve. Sur la figure 16 cette cuve comprend les emplacements pour les bras 21, qui maintiennent la cuve sur le rail. La figure 16 représente le système dit A1, comprenant la cuve plus tous les éléments nécessaires au chariot pour son déplacement. La figure 9 représente une cellule thermoélectrique à effet SEEBECK, pour la compréhension des deux différentes face et leur utilisation. La figure 10, représente la partie basse dite A2, et tous les éléments dont elle est composée. La figure 12, représente une partie du sandwich, et spécialement la construction des parties du sandwich concernant la solution technique pour la conduction et l'isolation thermique de la partie basse, concernant la conduction thermique de la partie 15, et l'isolant de la partie 18, étant scellé ensemble. La figure 14, représente une vue de face de la FIG 10, permettant de voir les entrées et sorties 14a et 14b pour le liquide froid. La figure 13, représente la partie dite sandwich, seul avec tous ces éléments montrant la construction ainsi que la solution technique pour encaisser et maintenir la ou les cellules thermoélectriques au milieu ainsi que l'apport en chaleurs a ces deux faces respectives pour le chaud et le froid. La figure 8 montre comment se connecte la partie A1 et A2, dans le but de transmettre la chaleur de la partie (7), de A1 à la partie (15) de A2, qui fournissent la chaleur par conduction thermique à la cellule thermoélectrique (17) plus particulièrement pour sa face chaude (17a). La figure 14, représente tous les éléments nécessaires en vue éclatée, à la construction de la partie basse, dite A2. La figure 17, est une vue complète mise à part le système Fresnel, de lentille, montrant tous les éléments constituant la totalité du système du chariot ainsi que les deux parties A1, l'une étant en recharge sur son cube l'autre étant en contact avec la partie basse A2. La figure 18 est une vue de face permettant une meilleure vue spécialement la plateforme (24) et le vérin (24)a, et la barre (25) liant la deux partie A2 avec le cube thermos ensemble. Sur la FIG 15, le rayonnement solaire passe à travers une lentille de Fresnel (1) maintenue dans son cadre porteur (2), le rayonnement solaire est concentré par cette lentille Fresnel et est orienté et focalisé de façon à obtenir une température souhaitée sur un point focal précis, dans le but de maintenir la température souhaitée, comme le ferait un homme du métier ou un ingénieur spécialisé en science de l'optique. Le point chaud de la lentille de Fresnel est utilisé pour chauffer une plaque (11) de préférence en graphène ou dans un matériau a haute conduction thermique, pour fondre de préférence du nitrate de lithium injecter a l'intérieur de la cuve. Le système utilise l'énergie thermique du nitrate de lithium fondue par conduction thermique, pour le coté chaud de la cellule Seebeck, FIG 9 (17a). FIG 15, le cadre porteur (2) de la lentille de Fresnel (1) est orientable par moteur électrique (4) du type pas à pas en vue de suivre la course du soleil, afin de garder son orientation de concentration des rayons solaires sur un point focale du point chaud sur la plaque (11) le cadre mobile (2), est construit afin de loger des moteurs pas à pas (4), le cadre (2), est fixé par des bras en métal (3), lesquels ont pour fonction de maintenir, les moteurs (4), Le cadre (2), qui lui maintient la lentille (1), les bras (3), sont scellés au sol. Le nitrate de lithium est contenu dans le cube en verre (11)(6) et (7) dit la cuve. La cuve, FIG 6 elle est constituée de quatre parties. (6) Une forme de cube en verre sans fond, Le sommet (11) du cube en graphène de préférence (6) est scellée par des rivets (10) sur le haut de la partie (5) le fond du cube (7) est construit dans un matériel a haut coefficient de conduction thermique de préférence en graphène pour ces qualités de conduction thermique, mais peut être construit avec un autre matériel de très bonne conduction thermique. Le fond du cube en graphène (7) est scellé sur les quatre parois verticales en verre (6) par des rivets (10) situées aux quatre coins de la plaque (7). A l'extérieur des côtés du cube en verre (6) un corps (5) l'entoure, comportant un espace entre le corps (5) et les parois en verre (6) l'espace (8) étant de l'air, ajoutant un principe d'isolation thermique. L'intérieur de la cuve en verre (6) avec fond en graphène (7) étant donc hermétique, une pression d'une atmosphère à 0 M au niveau de la mer étant considérée comme satisfaisant. Une valve de pression (9) située sur un des côtés de la cuve (5) et du cube en verre (6) traverse le corps (5) et (6) percé pour accueillir la valve/clapet de pression (9) prévue à cet effet. L'utilité de ce clapet (9) est d'aspirer l'air ambiant de la cuve (11)(6) et (7) dans le but d'enlever l'oxygène et le maximum d'humidité de l'air à l'intérieur de celle-ci, et de remplacer par de l'azote gazeux, a une pression d'une atmosphère. Le nitrate de lithium étant corrosif et oxydant, ajouter des parois en verre permet de réduire fortement le problème de corrosion et d'oxydation, et le remplacement fréquent de la cuve, (11)(6)(7). De plus le fait d'avoir un effet thermos, avec l'espace d'air (8) entre les parois latérales de verre (6) et du corps (5) apporte une solution pour minimiser la perte thermique par les côtés de la cuve (6)(5). La valve de pression (9) apporte aussi la solution et l'avantage, de vider l'air ambiant à l'intérieur de la cuve (11)(6) et (7) et de le remplacer par de l'azote gazeux, ainsi supprime le fait ou minimise fortement le fait que le nitrate de lithium puisse absorber de l'humidité de l'air ambiant. Le nitrate de lithium, étant injecter ensuite, par le clapet (9) seulement au moment où l'air ambiant a été aspirer et a été remplacé par de l'azote gazeux à une atmosphère. Le nitrate de lithium, peut être ensuite fondue par la lentille de Fresnel (1) dont le point focal du point chaud est régler de façon à atteindre la température nécessaire à travers le sommet de la cuve (11) dans le but d'utilisé le dit Nitrate de lithium fondue, comme source de chaleur par conduction thermique à travers le fond en graphène (7) en remplacement d'une flamme ou résistance, dans le système classique. La partie haute (A1) FIG 6, et FIG 16. La dénomination partie haute (A1) comprend le container de nitrate de lithium, c'est-à-dire tous les éléments de (5) à (11) en un seul ensemble compacte, plus les éléments du chariot (21) (22) (23). La partie basse (A2) FIG 10 et FIG 12, la dénomination (A2) comprend tous les éléments de (14) à (20). La partie basse FIG 10, est constituée d'un réservoir en aluminium (14) ayant une entrée (14a) et une sortie (14b) pour la circulation d'un liquide froid à l'intérieur du réservoir. Le réservoir (14) n'a pas de plaque du haut. Un système sandwich FIG 13 est posé sur le réservoir (14) le sandwich a deux rôles, le premier est de maintenir la ou les cellules thermoélectriques (17) plaquées entre les plaques de graphène (15) et (16) pour permettre un bon transfert de chaleur par conduction a la cellule thermoélectrique (17). Mais aussi d'avoir par le biais des plaques en verre maintenant les plaques de graphène scellé au milieu de l'ensemble (18)(15) FIG 14. Une isolation thermique entre la plaque du haut (18)(15) et le bas (19)(16) FIG 13. Description du sandwich, FIG 13 (15), (16), (17), (18), (19), (20) ce système comprend la plaque (15) en graphène ou autre matériel a haute conductivité thermique, qui est scellé au milieu de la plaque en verre (18) ou un autre matériel isolant, mais devant résister a une température de plus de 300 degrés Celsius. FIG 14 formant un ensemble unique, FIG 14, la plaque (19) et (16) est construite de la même manière, que la plaque (15), (18) FIG 10 les plaques (18), (15) et (19), (16) sont maintenue ensemble par les rivets (20) FIG 13. La plaque (19) est maintenue au réservoir (14) par les rivets (20A) FIG 10. Les cellules thermoélectriques à effet Seebeck FIG 9 utilisées dans notre système sont de forme carrée et plate, face chaude (17a) face froide (17B). Le sandwich FIG 13 maintient un contact entre les plaques de graphène (15)(16) les faces d'une ou des cellules (17) thermoélectrique, permettant une bonne conduction thermique du graphène aux deux côtés des cellule thermoélectrique, (17a) pour la face chaude et (17b) pour le froid, FIG 9 (17), (17a) et (17b). De sorte que : Le nitrate de lithium transmet la chaleur de la plaque (7) A (15) FIG 8, la partie haute (15) transmet vers (17a) FIG 9. Le froid provenant du liquide de refroidissement, qui s'écoule dans (14) de (14a) à (14b) traversant (14) le froid est transmis par conduction à la partie basse (16) qui transmet vers (17b) FIG 9. FIG 13 la raison pour laquelle le verre est choisi et entoure la pièce en graphène (15)(18) et (19)(16), est de limiter le transfert de chaleur de la pièce (15), à (18) et de (18) à (20), de (20) à (19), mais aussi parce qu'il faut un matériel qui puisse résister à la température sans fondre ou prendre feu, tout en étant un isolant car (19) entoure la pièce en graphène (16),qui elle a pour but le transfert du froid a la face froide (17b) de la cellule thermoélectrique. Si trop de chaleur était transmis à la pièce (16), le refroidissement du liquide froid sur la pièce (16), serai moins efficace, et donc la production électrique serai moindre, car l'effet Seebeck thermoélectrique résulte du delta de température entre le froid et le chaud, le fait d'isoler du chaud au mieux la pièce (16) FIG 13,qui conduit le froid à 17B,FIG 9 conduit à une meilleur production électrique, qui sans cela nécessiterai une eau plus froide pour compenser le fait que la pièce (16) ,soit chauffer par la conduction thermique de la pièce (15). Le système de liquide de refroidissement, est un design classique, un liquide froid circule à l'aide d'une pompe à eau, passe à l'intérieur du réservoir par l'entrer (14a) et le remplis complètement (14), et en ressort sur le côté opposer (14b) Ainsi le flux de liquide froid passant dans le réservoir (14), refroidissant par conduction thermique la plaque basse en graphène (16),cette plaque (16),transmet le froid du liquide par conduction à la face froide de la cellule thermoélectrique Seebeck (17b) FIG 9 et FIG 13. Le liquide peut être tout simplement de l'eau froide, provenant d'un bassin ou autre, retournant dans le bassin pour y être refroidi naturellement par perte thermique. Ensuite, le liquide est pompé à nouveau du bassin dans le réservoir (14) circulant de même manière dans le même circuit de liquide froid, de (14A) et (14b). Concernant la mise en contact de la partie(A1), et le sandwich de la partie (A2), FIG 8 la plaque en graphène (15), FIG 10, à de préférence le même diamètre ou la même forme géométrique que la plaque de graphène du fond de cuve (7) FIG 6, le but étant de pouvoir être mis en contact, pour assurer une conduction thermique entre le fond de cuve (7), et de la plaque (15), à travers les plaques de graphène, FIG 8. Assurant ainsi le transfert de chaleur du nitrate de lithium à travers la plaque de graphène (7), à la plaque du haut (15), FIG 8 assurant le transfert de chaleur par conduction thermique de (15), à la face de la cellule thermoélectrique (17a).

Fonctionnement sans soleil. Quand le soleil devient insuffisant, et donc la lentille de Fresnel 1, FIG 15 n'apporte plus assez de chaleur, au nitrate de lithium, il se produit un refroidissement, qui engendre due a la baisse de chaleur, une baisse de production électrique des cellules (17), à effet Seebeck. Pour remédier à ce problème, le chariot est mobile, grâce a un ensemble coulissant de gauche à droite, ou une nouvelle partie haute (A1) FIG 16, prend la place de l'ancienne. Les moteurs (22) roulent le long du rail (23). Vue d'ensemble FIG 17, la dénomination chariot comporte 2 parties (A1) relier entre elles par (25) plus les éléments (21), (22), (23), le chariot étant l'ensemble qui avance et recule. Le changement de partie haute (A1) intervient à la tombée de la nuit à détection de la chaleur insuffisante du Nitrate de lithium dans une partie haute (A1). Par exemple moins de 275 dégrée Celsius, dans le cas du nitrate de lithium qui fond aux environ de 255 Celsius. Le chariots étant un ensemble indépendant de la partie basse, (A2), FIG 18. La solution apportée par le chariot permet de changer de partie (A1), FIG 16, par une autre (A1), la nouvelle (A1) faisant office de pile à chaleur, ou stockage thermique, ayant été chargé durant la journée, mais dont la chaleur a été non utilisée. Ce chariot FIG 17, est composé de deux parties hautes, (A1) FIG 16, l'une à côté de l'autre, FIG 17. Les parties (A1), étant fixé via un bras métallique (21), permettant son soutien, sur le rail (23), ce bras métallique a un côté encastré dans la partie haute (5) FIG 6, et de l'autre côté du bras métallique est encastré dans un moteur électrique (22) le moteur électrique (22) roule sur un rail cranté (23), ce qui permet de faire avancer le chariot de droite à gauche, et gauche à droite. (A2) est scellé sur une plateforme (24), FIG 18 cette plateforme monte et descend de quelques centimètres par le biais d'un vérin hydraulique, (24a). Sur le côté de la partie basse(A2) un bras métallique (25) est fixé et s'étend de la partie basse (A2) à un cube thermos (26), FIG 17, de ce fait le cube thermos, (26) et la partie basse, (A2) suivent le même mouvement de haut en bas quand le vérin (24a) est activé. Le but étant de descendre la partie basse(A2) et le cube thermos (26), pour qu'ils ne soient plus en contact avec les parties hautes (7), de (A1), pendant le mouvement du vérin (24a) vers le bas. La partie (7), et (15), FIG 8, ne sont plus en contact, donc ne gêne pas le mouvement du chariot et des parties hautes (A1) en mouvement lors du changement de partie (A1), le cube thermos (26), étant relié à (A2) par le bras (25), descend aussi, donc la partie (7), est donc au-dessus du cube thermos (26) pour permettre à la nouvelle partie (A1), d'avancer sans toucher les bords haut du cube (26), et de prendre la place de l'ancienne (A1). Quand le vérin (24a) remonte, (7), et (15), FIG 8 sont de nouveau en contact, permettant à nouveau le transfert par conduction thermique. Le cube (26), en remontant, ayant un diamètre plus grand que (7), englobe la partie (7), pour minimiser les pertes thermiques, comme expliquer dans la partie cube thermos (26), ci-dessous. Le cube thermos (26), FIG 17, Il a pour utilité d'être placé juste dessous la partie haute (A1) qui est rechargée en énergie thermique durant la journée, et le rôle du cube est de minimiser les pertes thermiques à travers la plaque de graphène (7), de la partie(A1). Le cube thermos (26), est en verre est de forme de cube sans face haute. Il est vide contenant que de l'air, et son diamètre est plus grand que la plaque de graphène (7), de (A1) ce qui lui permet de venir s'encastrer sous la plaque en graphène (7), quand le vérin (24a) remonte. Le but est de minimiser les pertes thermiques via la plaque de graphène (7), qui serait plus importante si elle était à l'air libre. Le système n'étant pas hermétique, il n'y a donc pas de surpression causée par l'air chauffer dans le cube (26), due aux pertes thermiques, ce qui permet a l'air dilaté de s'échapper quand nécessaire. Les conduits de liquide froid (14A) et (14b) sont suffisamment longs et flexibles pour ne pas être un problème lors du mouvement de la partie basse (A2), de haut en bas. Il en va de même pour le circuit électrique connectant les cellules thermoélectrique Seebeck (17) de la partie basse(A2).

### LES ÉTAPES DU CHARIOT.

Le vérin (24a) abaisse la partie basse(A2), et le cube thermos (26), est solidaire avec la partie (A2), reliés ensemble par le bras (25), donc suit le même mouvement. A ce moment, le chariot peut avancer, via les moteurs (22), sur le rail (23), quand le chariot avance il y a changement de partie haute (A1), au moment où la nouvelle partie haute (A1) est en place en face de la partie basse (A2). Le vérin (24a) remonte et la partie basse (A2) est de nouveaux en contact avec la nouvelle partie haute (A1) FIG 8. De sorte que l'échange de chaleur thermique par conduction thermique via la plaque (7) avec (15), FIG 8 ce qui apporte la chaleur à la face (17a) FIG 9, de la cellule Seebeck. Dans ce cas, la nouvelle partie haute (A1) fait office de Pile à chaleur ou pile solaire qui a été chauffée préalablement et a emmagasiné de l'énergie thermique, toute la journée, sans la restituer, sauf les pertes. Où autrement appelé stockage thermique, cette autre partie haute (A1) remplace la partie haute (A1) dont la chaleur thermique est épuisée ou insuffisante. Son énergie thermique est donc restituée par le même système de conduction thermique plaque (7) avec (15), et face (17a), et est donc utilisée jusqu'à épuisement de celle-ci. Si besoin ou une ou plusieurs parties haute(A1) peuvent être utilisé pendant le soir et pendant la nuit. Dans ce cas précis il y aurait plusieurs parties hautes (A1) côte à côte sur le chariot, de sorte par exemple trois parties hautes(A1) au lieu de deux, dont deux serviront de stockage thermique pendant la journée, dans ce cas le chariot serait composé de trois parties hautes (A1) au lieu de deux, et de deux cubes thermos(26)et de deux bars (25), dont une (25) serai le liens entre deux cube thermos (26). Au prochain lever de soleil, quand les rayons solaires concentré via la lentille de Fresnel (1), réchauffe à nouveau la plaque (11) qui fond le nitrate de lithium lequel emmagasine de la chaleur pour un nouveau cycle. Le nitrate de lithium ou un autre medium est fondu à nouveau ou retrouve sa température de fonctionnement de 300 dégrées Celsius détecter par un thermomètre par exemple, le chariot reprend sa configuration de départ. Ainsi, les containers de nitrate de lithium sont rechargés en énergie thermique par la lentille de Fresnel (1) fondant le nitrate de l'lithium pour un nouveau cycle journalier. De ce fait, les cellules thermoélectriques à effets Seebeck assurent une production électrique, constante dès le moment où une différence de température chaud/froid est fournie à chacune de leur face. La température froide étant toujours assuré par la circulation d'eau froide dans la partie (A2), que ce soit de jour ou de nuit.

Le présent exemple peut être résumé par les clauses ci-dessous :
Clause 1 : le procédé est dit vert ou renouvelable car la chaleur nécessaire au fonctionnement des cellules thermoélectrique a effet Seebeck est produite par le rayonnement solaire passant à travers une lentille de Fresnel (1), utilisé pour fondre du nitrate de lithium, ou une autre solution ayant un rôle caloporteur, de préférence nitrate de lithium pour ces qualité de stockage et restitution thermique.
Clause 2 : L'isolation par les parties en verre (18), (19), (20), du sandwich, et le système de vis ou rivets du haut et du bas ont pour but d'empêcher au maximum le réchauffement de la plaque (16), par conduction thermique de la plaque (15).
Clause 3 : La chaleur du nitrate de lithium ou autre medium caloporteur, fondue est utilisé pour transmettre par conduction thermique la chaleur nécessaire au cellule thermoélectrique Seebeck, pour le coté chaud de la cellule.
Clause 4 : Le contenant du medium caloporteur est hermétique a l'air à une atmosphère au niveau de la mer, grâce à un clapet de pression, (9), ayant pour but de permettre d'aspirer l'air ambiant, afin de le remplacer par de l'azote gazeux, dans le but de limiter l'absorption de l'humidité de l'air ambiant par le nitrate de lithium, et de remplir la cuve en nitrate de lithium.
Clause 5 : Le design de la cage de verre en forme de cube (6) et sans parois du fond, le fond (7) étant en matériau de conduction thermique le plus élevé possible et sceller à la cage de verre (6) constituant un seul ensemble hermétique le matériau du fond étant de préférence le graphène. La cuve en verre (6) Le verre ayant l'avantage de limiter la corrosion et l'abrasion sur des parties qui seraient sinon en métal ou sensible à la corrosion ou oxydation par exemple. 6) Les pertes thermiques sont minimiser par le design de type thermos, par les parois de verre (6), et l'espace d'air (8) entre le verre et la paroi aluminium (5) contenant de l'air, permettant que le maximum de chaleur soit conservé et utilisé par conduction thermique à travers le graphène (7)
Clause 6 : Le sandwich (15)(18)(17)(19)(16)(20) maintenant les cellules thermoélectriques au milieu du sandwich, offre une solution a la fois de bon rendement de conduction thermique aux cellules (17) aussi bien pour le coté chaud et coté froid du fait de la propriété thermique du graphène, et assure aussi un principe isolant par les parties (18) (19) (20) minimisant une conduction thermique de la partie (15) a (16)
Clause 7 : La partie haute A1 et la partie basse A2 sont séparable, permettant de remplacer la partie haute contribuant à un constant apport de chaleur par conduction thermique, par une nouvelle partie haute agissant comme stockage thermique, « pile à chaleur » ou pile solaire, offre la solution de fonctionner sans soleil et ou pendant la nuit.
Clause 8 : Le vérin permet de descendre et de remonter à la fois la partie basse, et le cube thermos, lors du changement de la partie haute.
Clause 9 : Le système de chariot mobile permet le changement de partie haute, automatiquement permettant un apport de chaleur par conduction thermique, par la solution de remplacement d'une autre partie haute ayant le rôle de pile à chaleur, pouvant servir lors d'absence de soleil, ou de nuit. Pour que le système continue de produire de l'électricité.

## Revendications

1. Procédé de production d'électricité, comprenant les étapes de :
(a) conversion d'énergie en chaleur;
(b) stockage de l'énergie sous forme de chaleur selon l'étape (a) ;
(c) production d'électricité en utilisant la chaleur stockée de l'étape (b) nécessaire pour le côté chaud dans une cellule thermoélectrique (17) à effet Seebeck ; et
(d) récupération de l'électricité générée par l'étape de production (c) **caractérisé en ce que** l'étape (a) de conversion d'énergie en chaleur se fait à partir d'un flux d'au moins une onde électromagnétique dans laquelle ledit flux est concentré par un élément optique, tel qu'une lentille ou un miroir et que l'étape (b) de stockage de l'énergie sous forme de chaleur selon l'étape (a) se fait sur un produit caloporteur.

2. Procédé de production d'électricité selon la revendication 1, **caractérisé en ce que** la quantité et/ou la qualité de produit caloporteur de l'étape (a) et (b) sont adaptées pour une production d'électricité jour-et-nuit lorsque le flux d'au moins une onde électromagnétique provient du soleil.

3. Procédé de production d'électricité selon la revendication 1 ou 2 **caractérisé en ce que** le produit caloporteur de l'étape (b) est un sel fondu ou susceptible de fondre lorsqu'il est soumis au flux concentré par un élément optique.

4. Procédé de production d'électricité selon la revendication 3 **caractérisé en ce que** le sel fondu est choisi dans la liste consistant en du nitrate de lithium, nitrate de calcium, nitrate de sodium et nitrate de potassium.

5. Dispositif de production d'électricité adapté pour la mise en œuvre du procédé selon l'une quelconque des revendications 1 à 4 comprenant :
- un élément optique, tel qu'une lentille ou un miroir ;
- un produit caloporteur disposé de manière à recevoir l'énergie issue d'un flux d'au moins une onde électromagnétique concentré par l'élément optique ;
- au moins une cellule thermoélectrique (17) à effet Seebeck comprenant un corps froid configuré pour générer une différence de température avec le produit caloporteur ; et
- au moins un moyen de récupération de l'électricité produite.

6. Dispositif de production d'électricité selon la revendication 5 **caractérisé en ce qu'**il comprend une cage de verre.

7. Dispositif de production d'électricité selon la revendication 5 ou 6 comprenant des parois, **caractérisé en ce qu'**au moins une partie des parois comprends un matériau permettant une diffusion facilitée de la chaleur, tel que le graphène, préférentiellement la cellule thermoélectrique (17) à effet Seebeck est en contact avec le matériau permettant une diffusion facilitée de la chaleur.

8. Utilisation d'un élément optique, tel qu'une lentille de Fresnel (1) ou un miroir pour concentrer un flux d'au moins une onde électromagnétique avec une cellule thermoélectrique (17) à effet Seebeck comprenant un corps froid, dans laquelle l'élément optique est orienté de manière à chauffer un produit caloporteur.

9. Utilisation selon la revendication 8 **caractérisée en ce que** le produit caloporteur est un sel fondu ou susceptible d'être fondu lorsqu'il est soumis au flux concentré par un moyen optique, dans le but de stocker de l'énergie thermique, dans ledit sel fondu afin d'être utilisé comme une pile thermique.

10. Utilisation d'un dispositif de production d'électricité selon l'une quelconque des revendications 5 à 7 pour fournir de l'électricité à un réseau électrique public, fournir de l'électricité domestique ou industrielle
